# EUROPEAN PATENT APPLICATION

(11) **EP 4 746 112 A1**
(43) Date of publication of application: **20.05.2026**
(21) Application number: 25841474.7
(22) Date of filing: 12.06.2025
(51) Int. Cl.: H01M 10/42, H01M 10/04, G05B 19/418, G06Q 50/04, G06F 11/34, G01N 21/88, G01N 21/84

(54) **DATA ANALYSIS DEVICE AND METHOD FOR ANALYZING BATTERY MANUFACTURING PROCESS**

(30) Priority: 15.07.2024 KR 20240092833
(71) Applicant: LG Energy Solution, Ltd., Seoul 07335 (KR)
(72) Inventor: CHO, Hyung Jun, Daejeon 34122 (KR); PARK, Je Sung, Daejeon 34122 (KR); KIM, Jongwoo, Daejeon 34122 (KR); LEE, Jeongyul, Daejeon 34122 (KR); LEE, Jiseok, Daejeon 34122 (KR); HONG, Seung Gyun, Daejeon 34122 (KR)
(74) Representative: Goddar, Heinz J.
(86) International application number: PCT/KR2025/008046
(87) International publication number: WO 2026/019077

(57) **Abstract**

A data analysis device according to one embodiment of the present invention is linked to: a battery inspection device for determining whether batteries to be inspected are defective; and an identifier collection device for collecting the identifiers of batteries to be packaged, and may comprise: at least one processor; and a memory for storing at least one instruction executed through the at least one processor. The at least one instruction can include the instructions of: collecting, from the battery inspection device, inspection information about the batteries to be inspected; collecting, from the identifier collection device, packaging information including the identifiers of the batteries to be packaged; and generating performance information about the battery inspection device by using the inspection information and the packaging information.

## Description

### [Technical Field]

This application claims priority to and the benefit of Korean Patent Application No.10-2024-0092833 filed in the Korean Intellectual Property Office on July 15, 2024 the entire contents of which are incorporated herein by reference.

The present invention relates to a data analysis apparatus and method, and more particularly, to a data analysis apparatus and method for analyzing a battery manufacturing process.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries, capable of recharging and reuse, may be used as an energy source for small devices such as mobile phones, tablet PCs and vacuum cleaners, and also used as an energy source for medium and large devices such as personal mobility, automobiles and an energy storage system (ESS) for smart grids.

Battery cells are manufactured through assembly and activation processes. Because battery cells are assembled in a discharged state, the activation process after the assembly process activates positive electrode active material and forms a solid electrolyte interface (SEI) on the negative electrode, enabling the battery to function. This activation process is called a formation process.

During the activation process, gases generated within the cell may cause the cell to expand, resulting in appearance defects. Furthermore, external impacts during transport of cells after completion of the activation process may also cause appearance defects in a cell.

Typically, to detect these defective batteries, an appearance inspection using a battery tester or a visual inspection by an inspection worker may be performed after the activation process. Here, defective batteries are discarded, whereas those found to be normal are packaged using a packaging device and shipped.

Among the prior art documents relevant to the present invention, KR 10-2019-0035199 A is of some relevance.

### [Detailed Description of the Invention]

### [Technical Problem]

To obviate one or more problems of the related art, embodiments of the present disclosure provide a data analysis apparatus for analyzing battery manufacturing processes.

To obviate one or more problems of the related art, embodiments of the present disclosure also provide a data analysis method performed by the data analysis apparatus.

To obviate one or more problems of the related art, embodiments of the present disclosure also provide a battery manufacturing system including the data analysis apparatus.

### [Technical Solution]

In order to achieve the objective of the present disclosure, a data analysis apparatus, connected to a battery inspection apparatus that determines whether batteries subject to inspection are defective; and an identifier collection apparatus that collects identifiers of batteries subject to packaging, may include at least one processor; and a memory configured to store at least one instruction executed by the at least one processor.

The at least one instruction may include an instruction to collect inspection information on the batteries subject to inspection from the battery inspection apparatus; an instruction to collect packaging information including identifiers of the batteries subject to packaging, from the identifier collection apparatus; and an instruction to generate performance information on the battery inspection apparatus using the inspection information and the packaging information.

The instruction to collect the inspection information may include an instruction to collect identifiers of the batteries subject to inspection and an inspection result indicating whether each of the batteries subject to inspection is defective.

The instruction to collect the packaging information may include an instruction to collect identifiers of the batteries subject to packaging, which have been determined to be normal and are to be packaged by a packaging device.

The batteries subject to packaging may include at least one battery determined to be normal by the battery inspection apparatus; and at least one battery determined to be defective by the battery inspection apparatus but determined to be normal upon inspection by a worker.

The instruction to collect the packaging information may include an instruction to collect identifiers of each of the batteries subject to packaging from the identifier collection apparatus that recognizes an identification code indicated on the exterior of a battery.

The instruction to generate the performance information on the battery inspection apparatus may include an instruction to calculate an over-inspection rate of the battery inspection apparatus using the inspection information and the packaging information.

The instruction to calculate the over-inspection rate of the battery inspection apparatus may include an instruction to select at least one battery included in the batteries subject to packaging from among the batteries that have been determined to be defective by the battery inspection apparatus; and an instruction to calculate the over-inspection rate of the battery inspection apparatus based on a number of selected batteries.

The instruction to calculate the over-inspection rate of the battery inspection apparatus may include an instruction to calculate a ratio between the number of selected batteries and a number of batteries determined to be defective by the battery inspection apparatus.

The instruction to generate the performance information on the battery inspection apparatus may include an instruction to calculate an actual defect rate for batteries subject to inspection using the inspection information and the packaging information.

The instruction to calculate the actual defect rate for the batteries subject to inspection may include an instruction to calculate the actual defect rate based on the difference between a number of batteries subject to inspection and a number of batteries subject to packaging.

According to another embodiment of the present disclosure, a data analysis method, performed by a data analysis apparatus, connected to a battery inspection apparatus that determines whether batteries subject to inspection are defective; and an identifier collection apparatus that collects identifiers of batteries subject to packaging, may include collecting inspection information on the batteries subject to inspection from the battery inspection apparatus; collecting packaging information including identifiers of the batteries subject to packaging, from the identifier collection apparatus; and generating performance information on the battery inspection apparatus using the inspection information and the packaging information.

The collecting of the inspection information may include collecting identifiers of the batteries subject to inspection and an inspection result indicating whether each of the batteries subject to inspection is defective.

The collecting of the packaging information may include collecting identifiers of the batteries subject to packaging, which have been determined to be normal and are to be packaged by a packaging device.

The batteries subject to packaging may include at least one battery determined to be normal by the battery inspection apparatus; and at least one battery determined to be defective by the battery inspection apparatus but determined to be normal upon inspection by a worker.

The collecting of the packaging information may include collecting identifiers of each of the batteries subject to packaging from the identifier collection apparatus that recognizes an identification code indicated on the exterior of a battery.

The generating of the performance information on the battery inspection apparatus may include calculating an over-inspection rate of the battery inspection apparatus using the inspection information and the packaging information.

The calculating of the over-inspection rate of the battery inspection apparatus may include selecting at least one battery included in the batteries subject to packaging from among the batteries that have been determined to be defective by the battery inspection apparatus; and calculating the over-inspection rate of the battery inspection apparatus based on a number of selected batteries.

The calculating of the over-inspection rate of the battery inspection apparatus may include calculating a ratio between the number of selected batteries and a number of batteries determined to be defective by the battery inspection apparatus.

The generating of the performance information on the battery inspection apparatus may include calculating an actual defect rate for batteries subject to inspection using the inspection information and the packaging information.

The calculating of the actual defect rate for batteries subject to inspection may include calculating the actual defect rate based on the difference between a number of batteries subject to inspection and a number of batteries subject to packaging.

According to another embodiment of the present disclosure, a battery manufacturing system may include a battery inspection apparatus configured to determine whether batteries subject to inspection are defective; a packaging device configured to package batteries finally determined to be normal; an identifier collection apparatus configured to collect identifiers of each battery subject to packaging; and a data analysis apparatus configured to generate performance information about the battery inspection apparatus.

Here, the data analysis apparatus may collect inspection information on the batteries subject to inspection from the battery inspection apparatus; collect packaging information including identifiers of the batteries subject to packaging, from the identifier collection apparatus; and generate performance information on the battery inspection apparatus using the inspection information and the packaging information.

### [Advantageous Effects]

According to embodiments of the present disclosure, it is possible to quickly calculate accurate performance indicators for a battery inspection apparatus using battery inspection information and packaging information.

### [Brief Description of the Drawings]

FIG. 1 illustrates a general battery manufacturing process.
FIG. 2 is an operational illustrating a battery inspection method performed after the activation process.
FIG. 3 is a block diagram of a battery manufacturing system according to embodiments of the present invention.
FIG. 4 is an operational flowchart illustrating a data analysis method according to an embodiment of the present invention.
FIG. 5 is an operational flowchart illustrating a data analysis method according to another embodiment of the present invention.
FIG. 6 is an operational flowchart illustrating a data analysis method according to another embodiment of the present invention.
FIG. 7 is a block diagram of a data analysis apparatus according to embodiments of the present invention.
   100: battery inspection apparatus
   200: packaging device
   300: identifier collection apparatus
   400: data analysis apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

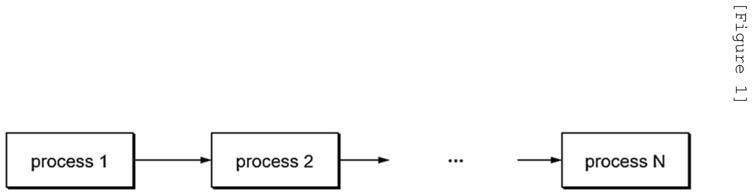

FIG. 1 illustrates a general battery manufacturing process.

Batteries may be manufactured by sequentially performing a plurality of unit processes. More specifically, the battery manufacturing process may be categorized into N unit processes, and the first through Nth processes may be sequentially performed to manufacture a battery.

For example, battery cells may be manufactured by sequentially performing unit processes classified as an electrode coating process (process 1), an electrode rolling process (process 2), an assembly process (process 3), an activation process (process 4), and an End-of-Line (EOL) process (process 5).

During an individual unit process or after battery manufacturing is completed, performance tests may be conducted to determine whether the battery exhibits the intended performance, and defect inspection may be conducted to determine whether the battery is defective.

Specifically, since battery cells are assembled in a discharged state, the battery cell assembly process (the third process) and subsequent activation process (the fourth process) are required to activate the positive electrode active material and form a surface film (SEI: Solid Electrolyte Interface) on the negative electrode, enabling the battery to function. This activation process is also known as the formation process.

During the activation process being proceeded, gases generated within the cell can cause the cell to expand, potentially resulting in appearance defects. Furthermore, external impacts during transport of cells after completion of the activation process can also cause an appearance defect in a cell.

Generally, an appearance inspection using a battery inspector or a visual inspection by a worker is performed after the activation process so as to detect these appearance-defective batteries. Here, defective batteries are discarded, while batteries found to be normal are packaged using a packaging device and shipped.

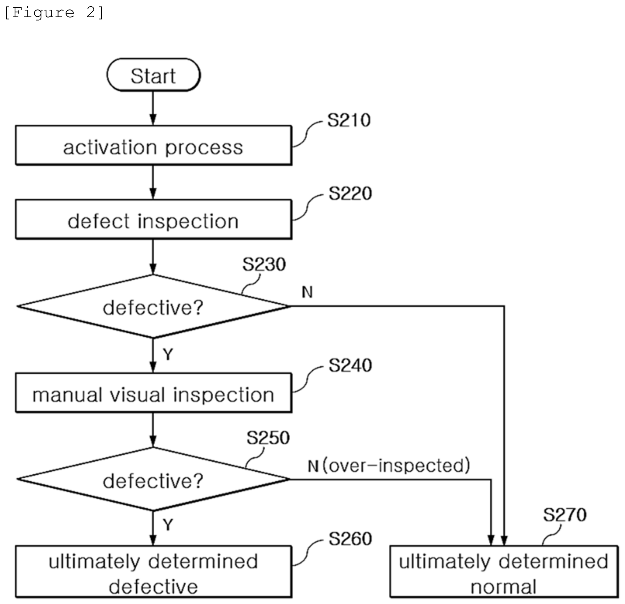

FIG. 2 is a flowchart illustrating a battery inspection method performed after the activation process.

Once the activation process (S210) is completed, a defect inspection using a battery inspection apparatus may be performed (S220). Here, the battery inspection apparatus may determine whether each battery cell sequentially transported on a transport lane is defective. For example, the battery inspection apparatus may use a non-destructive inspection method using an optical sensor to determine whether the appearance of each battery cell is outside a standard range, thereby determining whether each battery cell is defective (normal or defective).

Batteries that are determined to be normal (N in S230) as a result of the inspection by the battery inspection apparatus may be finally determined to be normal (S270) and shipped.

Batteries that are determined to be defective (Y in S230) as a result of the inspection by the battery inspection apparatus may be visually inspected by a worker (S240). For example, the visual inspection may be conducted by having an operator directly inspect the appearance of cells determined to be defective by the battery inspection apparatus, and then sorting out defective batteries.

Batteries determined to be defective (Y in S250) through the visual inspection may be ultimately determined to be defective (S260) and discarded.

Batteries determined to be normal (N in S250) through the visual inspection may be finally determined to be normal (S270) and shipped. Here, batteries determined to be normal through visual inspection are those that were initially determined to be defective by the battery inspection apparatus but are ultimately determined to be normal. These batteries may be considered over-inspected by the battery inspection apparatus (i.e., batteries that are actually normal but are determined to be defective).

To analyze the cause of performance degradation of the battery inspection apparatus and to implement corrective measures, a performance analysis of the battery inspection apparatus needs to be performed first. Here, utilizing additional precision inspection equipment to calculate the over-inspection rate and actual defect rate of the battery inspection apparatus may be considered. For example, a precision inspection apparatus may determine whether a sampled portion (e.g., 100 out of 10,000) of batteries that have been inspected by a battery inspection apparatus are defective. The results of the inspection by the battery inspection apparatus may be compared with those of the precision inspection apparatus to determine the over-inspection rate and actual defect rate of the battery inspection apparatus.

However, performance indicators calculated using this method are unreliable because they are calculated using a sampled portion of batteries, and performance analysis may be time-consuming.

The present invention relates to a technology that can quickly calculate accurate performance indicators for a battery inspection apparatus. Various embodiments of the present invention will be described in detail below with reference to the accompanying drawings.

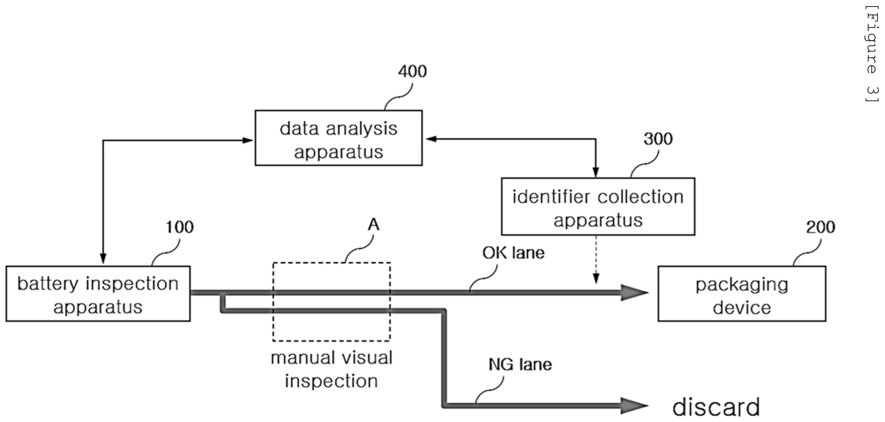

FIG. 3 is a block diagram of a battery manufacturing system according to embodiments of the present invention.

Referring to FIG. 3, the battery manufacturing system may include a battery inspection apparatus 100, a packaging device 200, an identifier collection apparatus 300, and a data analysis apparatus 400.

The battery inspection apparatus 100 may determine whether batteries subject to inspection are defective. Here, the battery inspection apparatus 100 may determine whether each battery cell, sequentially transported along a transport lane, is defective.

For example, the battery inspection apparatus 100 may use a non-destructive inspection method using an optical sensor to determine whether the appearance of the battery cell deviates from the standard range, thereby determining whether each battery cell is defective (normal or defective).

The packaging device 200 may package the battery before shipment. Here, the battery to be packaged by the packaging device 200 may be a battery that has been ultimately determined to be normal.

The batteries subject to packaging may include batteries determined to be normal by the battery inspection apparatus 100 and batteries determined to be defective by the battery inspection apparatus 100 but determined to be normal upon manual visual inspection.

Batteries that have been inspected by the battery inspection apparatus 100 may be transported along a first transport lane or a second transport lane, depending on the inspection results. Specifically, batteries determined to be normal (OK) by the battery inspection apparatus 100 may be transported via the first transport lane (OK lane). Additionally, batteries determined to be defective (NG) by the battery inspection apparatus 100 may be transported via the second transport lane (NG lane).

A manual visual inspection by a worker may be performed on at least some of the batteries inspected by the battery inspection apparatus 100. For example, as illustrated in FIG. 2, batteries inspected by the battery inspection apparatus 100 may be transported along the first transport lane (OK lane) or the second transport lane (NG lane) based on the inspection results. A manual visual inspection by a worker may be performed in Area A.

The visual inspection may be performed on batteries determined to be defective (NG) by the battery inspection apparatus 100. Specifically, the visual inspection may be conducted on batteries transported through the second transport lane (NG lane). For example, the visual inspection may be conducted by a worker who inspects the appearance of each battery transported through the second transport lane (NG lane) and selects defective batteries.

Batteries determined to be defective based on the visual inspection may be ultimately determined to be defective and discarded. For example, batteries determined to be defective based on the visual inspection may be transported to a waste battery collection area located at the end of the second transport lane (NG lane) and subsequently disposed of by a disposal device.

Batteries that are visually inspected and determined to be normal may be finally judged as normal and shipped. For example, batteries that are visually inspected as normal may be moved by a worker from the second transport lane (NG lane) to the first transport lane (OK lane), and then transferred to a packaging device 200 located at the end of the first transport lane (OK lane). Here, a battery that is visually inspected as normal is a battery that was previously judged as defective by the battery inspection apparatus 100 but is ultimately judged as normal, which means that the battery is considered over-inspected by the battery inspection apparatus (i.e., a battery that is actually normal but is judged as defective).

Batteries that are inspected by the battery inspection apparatus 100 and determined to be normal may be finally judged as normal and shipped. For example, a battery determined to be normal by the battery inspection apparatus 100 may be transported to the packaging device 200 via the first transport lane (OK lane) without performing a visual inspection. The battery may be packaged by the packaging device 200 and then shipped.

The identifier collection apparatus 300 may be a device that collects battery identifiers.

The battery subject to inspection according to the present invention may be pre-assigned an identifier, and an identification code corresponding to the identifier may be displayed on the exterior of the battery. For example, a barcode or a QR code (Quick Response code) corresponding to the identifier of the battery cell may be printed or affixed to the outer surface of a battery cell.

Here, the identifier collection apparatus 300 may recognize the identification code displayed or affixed to the exterior of the battery subject to inspection and confirm the identifier corresponding to the identification code. For example, the identifier collection apparatus 300 may include a barcode scanner or QR scanner and scan the identification code of a battery cell to identify the identifier of the corresponding battery cell.

The identifier collection apparatus 300 may collect identifiers for batteries subject to packaging. For example, as illustrated in FIG. 3, the identifier collection apparatus 300 may be positioned at the end of the first transport lane (OK lane) and collect identifiers of batteries subject to packaging immediately before they are packaged by the packaging device 200. In other words, the identifiers collected by the identifier collection apparatus 300 may be identifiers of batteries that have been ultimately determined to be normal.

The data analysis apparatus 400 may interwork with the battery inspection apparatus 100 and the identifier collection apparatus 300 to generate performance information for the battery inspection apparatus 100. Here, the performance information may include one or more of an over-inspection rate of the battery inspection apparatus and an actual defect rate of the inspected batteries.

In other words, the data analysis apparatus 400 according to embodiments of the present invention may calculate a performance index of the battery inspection apparatus by using the identifiers of the batteries subject to packaging (batteries that have been finally determined to be normal) collected immediately before packaging and the inspection information of the battery inspection apparatus. Accordingly, the performance index of the battery inspection apparatus calculated according to embodiments of the present invention exhibits high accuracy compared to a performance index calculated using some sampled batteries, and real-time monitoring is possible.

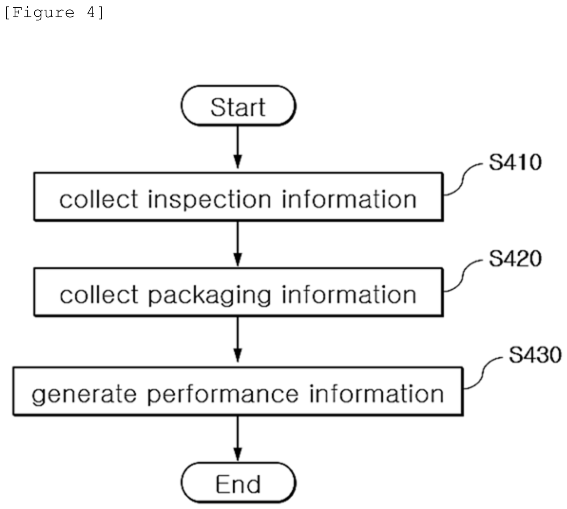

FIG. 4 is an operational flowchart illustrating a data analysis method according to an embodiment of the present invention.

The data analysis apparatus may collect inspection information from a battery inspection apparatus (S410). Here, the inspection information may include identifiers for each battery subject to inspection and inspection results (normal or defective). For example, if inspection of 100 batteries is completed, the data analysis apparatus may receive inspection information including {[#1; OK], [#2; OK], [#3; NG], [#4; OK], ... [#99; NG], [#100; OK]} from the battery inspection apparatus.

The data analysis apparatus may collect packaging information from an identifier collection apparatus (S420). Here, the packaging information may include identifiers for each battery subject to packaging. For example, the data analysis apparatus may receive packaging information including {#1; #2; #4; #5; ... #100} from a barcode scanner.

The data analysis apparatus may generate performance information about the battery inspection apparatus (S430) using the inspection information collected in step S410 and the packaging information collected in step S420. Here, the performance information may include at least one of an over-inspection rate of the battery inspection apparatus and an actual defect rate of the batteries inspected.

For example, the data analysis apparatus may use the inspection information and the packaging information to derive the number of over-inspected batteries and calculate the over-inspection rate of the battery inspection apparatus based on the number of over-inspected batteries. Here, the over-inspection rate may be defined as a ratio (N_od/N_d_ng) of the number of over-inspected batteries (N_od) and the number of batteries determined as defective by the battery inspection apparatus (N_d_ng).

For another example, the data analysis apparatus may use the inspection information and the packaging information to derive the number of actual defective batteries (batteries finally determined to be defective) and calculate the actual defect rate of the batteries inspected based on the number of actual defective batteries. Here, the actual defect rate may be defined as the ratio (N_r_ng/N_all) of the number of actual defective batteries (N_r_ng) and the number of inspected batteries (N_all).

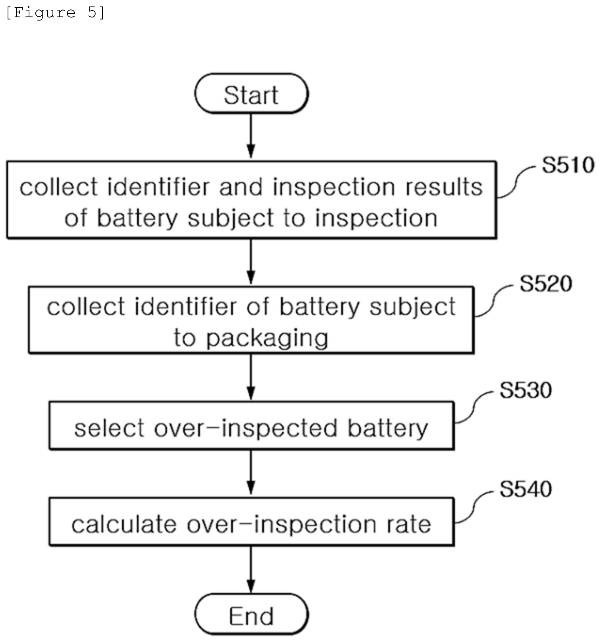

FIG. 5 is an operational flowchart illustrating a data analysis method according to another embodiment of the present invention. Hereinafter, with reference to FIG. 5, a method for calculating an over-inspection rate of a battery inspection apparatus according to embodiments of the present invention will be described in more detail.

The data analysis apparatus may collect inspection information, including the identifiers and inspection results (normal or defective) of each battery subject to inspection, from the battery inspection apparatus (S510). For example, if inspection of 100 batteries subject to inspection is completed, the data analysis apparatus may receive inspection information including {[#1; OK], [#2; OK], [#3; NG], [#4; OK], ... [#99; NG], [#100; OK]} from the battery inspection apparatus.

The data analysis apparatus may collect packaging information, including identifiers for each battery subject to packaging, from the identifier collection apparatus (S520). For example, the data analysis apparatus may receive packaging information including {#1; #2; #3; #4; #5; ... #100} from a barcode scanner.

The data analysis apparatus may select over-inspected batteries using the inspection information collected in step S410 and the packaging information collected in step S420 (step S530). Here, the over-tested battery may refer to a battery that has been determined as defective by the battery inspection apparatus but is actually normal.

Specifically, the data analysis apparatus may select batteries included in the battery subject to packaging among the batteries determined as defective by the battery inspection apparatus as over-inspected batteries. Here, the data analysis apparatus may select over-inspected batteries by comparing the identifiers of the batteries determined as defective, among the identifiers included in the inspection information, with the identifiers included in the packaging information.

For example, if the identifiers of batteries determined to be defective among the identifiers included in the inspection information are #3, #7, #15, #31, and #99, and the packaging information includes all identifiers except #7, #15, #31, and #99 among from #1 to #100, the data analysis apparatus may select the battery corresponding to #3 as an over-inspected battery. In other words, the batteries corresponding to #7, #15, #31, and #99 are determined to be defective by the battery inspection apparatus and are also determined to be defective in a subsequent visual inspection, and thus may be classified as batteries for disposal (finally determined as defective). On the other hand, the battery corresponding to #3 has been determined to be defective by the battery inspection apparatus, but is determined to be normal in the subsequent visual inspection and recognized just before packaging, and thus may be classified as an over-inspected battery.

Thereafter, the data analysis apparatus may calculate the over-inspection rate of the battery inspection apparatus based on the number of over-inspected batteries (S540). Here, the over-inspection rate may be defined as the ratio (N_od/N_d_ng) of the number of over-inspected batteries (N_od) and the number of batteries determined as defective by the battery inspection apparatus (N_d_ng).

In the above example, the number of over-inspected battery (#3) (N_od) is 1, and the number of batteries (#3, #7, #15, #31, #99) determined as defective by the battery inspection apparatus (N_d_ng) is 5. Therefore, the over-inspection rate may be calculated as 20% (1/5).

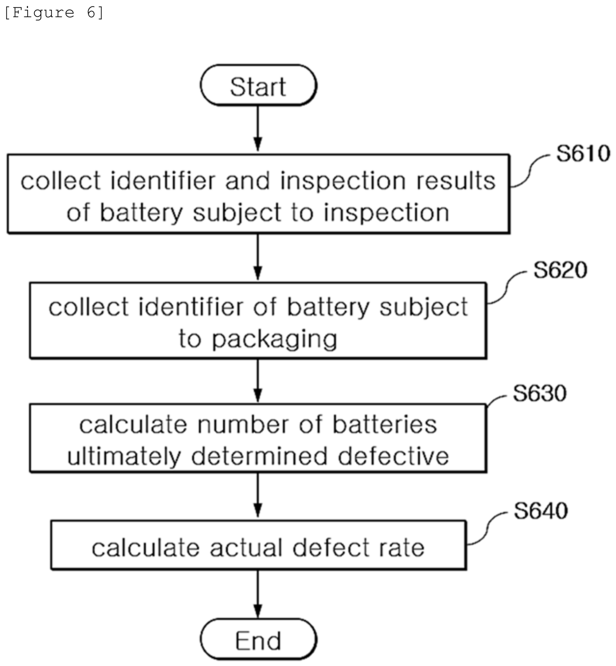

FIG. 6 is an operational flowchart illustrating a data analysis method according to another embodiment of the present invention. Hereinafter, with reference to FIG. 6, a method for calculating an actual defect rate of a battery subject to inspection according to embodiments of the present invention will be described in more detail.

The data analysis apparatus may collect inspection information, including the identifiers and inspection results (normal or defective) of each battery subject to inspection, from the battery inspection apparatus (S610). For example, if inspection of 100 batteries subject to inspection is completed, the data analysis apparatus may receive inspection information including {[#1; OK], [#2; OK], [#3; NG], [#4; OK], ... [#99; NG], [#100; OK]} from the battery inspection apparatus.

The data analysis apparatus may collect packaging information, including identifiers for each battery subject to packaging, from the identifier collection apparatus (S620). For example, the data analysis apparatus may receive packaging information including {#1; #2; #3; #4; #5; ... #100} from a barcode scanner.

The data analysis apparatus may calculate the number of actual defective batteries using the inspection information collected in step S410 and the packaging information collected in step S420 (step S630). Here, the actual defective battery may refer to a battery that was determined to be defective by the battery inspection apparatus and subsequently determined to be also defective by visual inspection, resulting in being ultimately determined defective.

Specifically, the data analysis apparatus may calculate the number of actual defective batteries based on the difference between the number of batteries subject to inspection and the number of batteries subject to packaging. Here, the data analysis apparatus may calculate the number of actual defective batteries by calculating the difference between the number of identifiers included in the inspection information and the number of identifiers included in the packaging information.

For example, if the number of identifiers included in the inspection information is 100 and the number of identifiers included in the packaging information is 96, the number of actual defective batteries may be calculated as 4.

Thereafter, the data analysis apparatus may calculate the actual defect rate of the inspected batteries based on the number of batteries inspected and the number of actual defective batteries (S640). Here, the actual defect rate may be defined as the ratio (N_r_ng/N_all) of the number of actual defective batteries (N_r_ng) and the number of batteries inspected (N_all).

In the above example, the number of actual defective batteries (N_r_ng) is 4, and the number of batteries inspected (N_all) is 100, so the actual defect rate may be calculated as 4% (4/100).

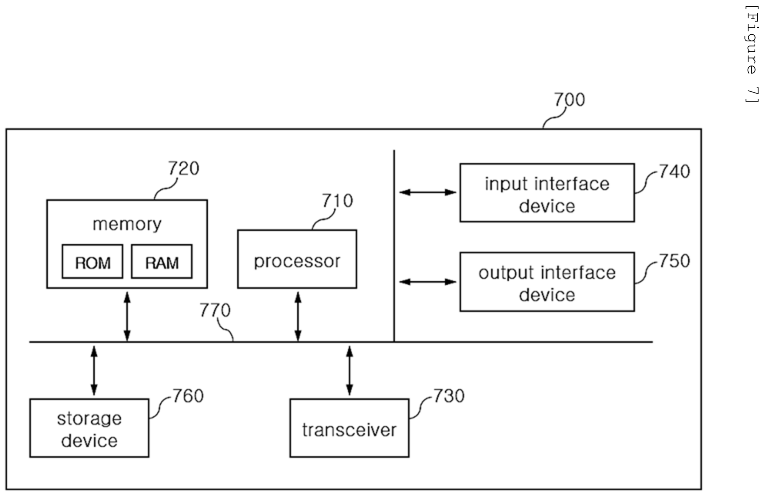

FIG. 7 is a block diagram of a data analysis apparatus according to embodiments of the present invention.

The data analysis apparatus 700 according to embodiments of the present invention may cooperate with a battery inspection apparatus which determines whether batteries subject to inspection are defective; and an identifier collection apparatus which collects identifiers of batteries subject to packaging, wherein the battery inspection apparatus and the identifier collection apparatus are included in a battery manufacturing system. Here, the data analysis apparatus 700 may correspond to an integrated monitoring apparatus of the battery manufacturing system or may be included in the integrated monitoring apparatus.

The data analysis apparatus 700 according to embodiments of the present invention may include at least one processor 710, a memory 720 that stores at least one command executed by the processor, and a transceiver 730 that is connected to a network and performs communication.

The at least one instruction may include an instruction to collect inspection information on the batteries subject to inspection from the battery inspection apparatus; an instruction to collect packaging information including identifiers of the batteries subject to packaging, from the identifier collection apparatus; and an instruction to generate performance information on the battery inspection apparatus using the inspection information and the packaging information.

The instruction to collect the inspection information may include an instruction to collect identifiers of the batteries subject to inspection and an inspection result indicating whether each of the batteries subject to inspection is defective.

The instruction to collect the packaging information may include an instruction to collect identifiers of the batteries subject to packaging, which have been determined to be normal and are to be packaged by a packaging device.

The batteries subject to packaging may include at least one battery determined to be normal by the battery inspection apparatus; and at least one battery determined to be defective by the battery inspection apparatus but determined to be normal upon inspection by a worker.

The instruction to collect the packaging information may include an instruction to collect identifiers of each of the batteries subject to packaging from the identifier collection apparatus that recognizes an identification code indicated on the exterior of a battery.

The instruction to generate the performance information on the battery inspection apparatus may include an instruction to calculate an over-inspection rate of the battery inspection apparatus using the inspection information and the packaging information.

The instruction to calculate the over-inspection rate of the battery inspection apparatus may include an instruction to select at least one battery included in the batteries subject to packaging from among the batteries that have been determined to be defective by the battery inspection apparatus; and an instruction to calculate the over-inspection rate of the battery inspection apparatus based on a number of selected batteries.

The instruction to calculate the over-inspection rate of the battery inspection apparatus may include an instruction to calculate a ratio between the number of selected batteries and a number of batteries determined to be defective by the battery inspection apparatus.

The instruction to generate the performance information on the battery inspection apparatus may include an instruction to calculate an actual defect rate for batteries subject to inspection using the inspection information and the packaging information.

The instruction to calculate the actual defect rate for the batteries subject to inspection may include an instruction to calculate the actual defect rate based on the difference between a number of batteries subject to inspection and a number of batteries subject to packaging.

The data analysis apparatus 700 according to embodiments of the present invention may further include an input interface device 740, an output interface device 750, a storage device 760, etc. Respective components included in the data analysis apparatus 700 may be connected by a bus 770 and communicate with each other.

Here, the processor 710 may mean a central processing unit (CPU), a graphics processing unit (GPU), or a dedicated processor on which methods according to embodiments of the present invention are performed. The memory (or storage unit) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A data analysis apparatus, connected to a battery inspection apparatus that determines whether batteries subject to inspection are defective; and an identifier collection apparatus that collects identifiers of batteries subject to packaging, the data analysis apparatus comprising:
at least one processor; and
a memory configured to store at least one instruction executed by the at least one processor,
wherein the at least one instruction includes:
an instruction to collect inspection information on the batteries subject to inspection from the battery inspection apparatus;
an instruction to collect packaging information including identifiers of the batteries subject to packaging, from the identifier collection apparatus; and
an instruction to generate performance information on the battery inspection apparatus using the inspection information and the packaging information.

2. The data analysis apparatus of claim 1, wherein the instruction to collect the inspection information includes:
an instruction to collect identifiers of the batteries subject to inspection and an inspection result indicating whether each of the batteries subject to inspection is defective.

3. The data analysis apparatus of claim 1, wherein the instruction to collect the packaging information includes:
an instruction to collect identifiers of the batteries subject to packaging, which have been determined to be normal and are to be packaged by a packaging device.

4. The data analysis apparatus of claim 3, wherein the batteries subject to packaging include:
at least one battery determined to be normal by the battery inspection apparatus; and
at least one battery determined to be defective by the battery inspection apparatus but determined to be normal upon inspection by a worker.

5. The data analysis apparatus of claim 3, wherein the instruction to collect the packaging information includes:
an instruction to collect identifiers of each of the batteries subject to packaging from the identifier collection apparatus that recognizes an identification code indicated on the exterior of a battery.

6. The data analysis apparatus of claim 1, wherein the instruction to generate the performance information on the battery inspection apparatus includes:
an instruction to calculate an over-inspection rate of the battery inspection apparatus using the inspection information and the packaging information.

7. The data analysis apparatus of claim 6, wherein the instruction to calculate the over-inspection rate of the battery inspection apparatus includes:
an instruction to select at least one battery included in the batteries subject to packaging from among the batteries that have been determined to be defective by the battery inspection apparatus; and
an instruction to calculate the over-inspection rate of the battery inspection apparatus based on a number of selected batteries.

8. The data analysis apparatus of claim 7, wherein the instruction to calculate the over-inspection rate of the battery inspection apparatus includes:
an instruction to calculate a ratio between the number of selected batteries and a number of batteries determined to be defective by the battery inspection apparatus.

9. The data analysis apparatus of claim 1, wherein the instruction to generate the performance information on the battery inspection apparatus includes:
an instruction to calculate an actual defect rate for the batteries subject to inspection using the inspection information and the packaging information.

10. The data analysis apparatus of claim 9, wherein the instruction to calculate the actual defect rate for the batteries subject to inspection includes:
an instruction to calculate the actual defect rate based on the difference between a number of the batteries subject to inspection and a number of the batteries subject to packaging.

11. A data analysis method performed by a data analysis apparatus, connected to a battery inspection apparatus that determines whether batteries subject to inspection are defective; and an identifier collection apparatus that collects identifiers of batteries subject to packaging, the data analysis method comprising:
collecting inspection information on the batteries subject to inspection from the battery inspection apparatus;
collecting packaging information including identifiers of the batteries subject to packaging, from the identifier collection apparatus; and
generating performance information on the battery inspection apparatus using the inspection information and the packaging information.

12. The method of claim 11, wherein the collecting of the inspection information includes:
collecting identifiers of the batteries subject to inspection and an inspection result indicating whether each of the batteries subject to inspection is defective.

13. The method of claim 11, wherein the collecting of the packaging information includes:
collecting identifiers of the batteries subject to packaging, which have been determined to be normal and are to be packaged by a packaging device.

14. The method of claim 13, wherein the batteries subject to packaging include:
at least one battery determined to be normal by the battery inspection apparatus; and
at least one battery determined to be defective by the battery inspection apparatus but determined to be normal upon inspection by a worker.

15. The method of claim 13, wherein the collecting of the packaging information includes:
collecting identifiers of each of the batteries subject to packaging from the identifier collection apparatus that recognizes an identification code indicated on the exterior of a battery.

16. The method of claim 11, wherein the generating of the performance information on the battery inspection apparatus includes:
calculating an over-inspection rate of the battery inspection apparatus using the inspection information and the packaging information.

17. The method of claim 16, wherein the calculating of the over-inspection rate of the battery inspection apparatus includes:
selecting at least one battery included in the batteries subject to packaging from among the batteries that have been determined to be defective by the battery inspection apparatus; and
calculating the over-inspection rate of the battery inspection apparatus based on a number of selected batteries.

18. The method of claim 17, wherein the calculating of the over-inspection rate of the battery inspection apparatus includes:
calculating a ratio between the number of selected batteries and a number of batteries determined to be defective by the battery inspection apparatus.

19. The method of claim 11, wherein the generating of the performance information on the battery inspection apparatus includes:
calculating an actual defect rate for the batteries subject to inspection using the inspection information and the packaging information.

20. The method of claim 19, wherein the calculating of the actual defect rate for the batteries subject to inspection includes:
calculating the actual defect rate based on the difference between a number of the batteries subject to inspection and a number of the batteries subject to packaging.

21. A battery manufacturing system comprising:
a battery inspection apparatus configured to determine whether batteries subject to inspection are defective;
a packaging device configured to package batteries finally determined to be normal;
an identifier collection apparatus configured to collect identifiers of each battery subject to packaging; and
a data analysis apparatus configured to generate performance information about the battery inspection apparatus,
wherein the data analysis apparatus collects inspection information on the batteries subject to inspection from the battery inspection apparatus; collects packaging information including identifiers of the batteries subject to packaging, from the identifier collection apparatus; and generates performance information on the battery inspection apparatus using the inspection information and the packaging information.
